Europäisches Patentamt

European Patent Office

Office européen des brevets

(11) Veröffentlichungsnummer: **0 452 805 A2**

# EUROPÄISCHE PATENTANMELDUNG

(21) Anmeldenummer: **91105742.0**

(22) Anmeldetag: **11.04.91**

(51) Int. Cl.5: **H03M 1/36**

(30) Priorität: **14.04.90 DE 4012196**

(43) Veröffentlichungstag der Anmeldung:
**23.10.91 Patentblatt 91/43**

(84) Benannte Vertragsstaaten:
**DE FR GB IT NL**

(71) Anmelder: **Nokia Unterhaltungselektronik (Deutschland) GmbH**
**Östliche Karl-Friedrich-Strasse 132**
**W-7530 Pforzheim(DE)**

(72) Erfinder: **Mitschke, Helmut**
**Obere Breitstrasse 8**
**W-7535 Königsbach-Stein(DE)**

(54) **A/D-Wandlerschaltung zum Digitalisieren analoger Fernsehsignale.**

(57) Eine A/D-Wandlerschaltung zum Digitalisieren analoger Fernsehsignale weist folgende Funktionsgruppen auf:

- einen A/D-Wandler (12) zum Zuordnen einer Anzahl m jeweils gleicher Teilspannungen $U\_T$ zu einer Signalspannung $U\_S$, wobei sich jede Teilspannung $U\_T$ als Referenzspannung/n berechnet, mit n = höchstmöglicher digitaler Wert,
- und eine Spannungssteuerschaltung (11), die die Referenzspannung so steuert, daß sie mit zunehmender Amplitude des analogen Fernsehsignals zunimmt.

Diese Schaltung hat den Vorteil, daß sie die Referenzspannung, also eine Gleichspannung, steuert. Demgegenüber steuern bekannte Schaltungen den Verstärkungsfaktor für einen Wechselspannungsverstärker für das zu digitalisierende Fernsehsignal.

Fig. 2

EP 0 452 805 A2

## TECHNISCHES GEBIET

Die Erfindung betrifft eine A/D-Wandlerschaltung zum Digitalisieren analoger Fernsehsignale. Der Begriff "Fernsehsignale" wird hierbei als Sammelbegriff für unterschiedlichste Signale verwendet, wie sie beim Verarbeiten von Information für Fernsehbilder auftreten. Zum Beispiel gehören zu diesen Signalen das FBAS-Signal (F = Farbartsignal, B = Bildsignal, AS = Austast- und Synchronisierpulse), die Farbwertsignale R, G und B, das Helligkeitssignal Y und die Farbdifferenzsignale V = R - Y und U = B - Y.

## STAND DER TECHNIK

Alle bekannten A/D-Wandlerschaltungen weisen einen A/D-Wandler zum Zuordnen einer Anzahl n jeweils gleicher Teilspannungen $U\_T$ zu einer Signalspannung $U\_S$ auf, wobei sich jede Teilspannung $U\_T$ als Referenzspannung/n berechnet, mit n = höchstmöglichem digitalem Wert. Bei typischen Anwendungen beträgt die Referenzspannung 2 V, und es sind n = $2^7$ = 128 digitale Werte unterscheidbar. Die Normspitzenspannung beträgt 1,0 V an 75 Ohm. Die Spannung wird in der Regel um den Faktor 2 verstärkt, bevor sie gewandelt wird. Das Hauptproblem beim Wandeln besteht darin, daß bei vielen Signalen die Spitzenspannung vom Normwert abweicht, wobei Abweichungen von +/- 30 % keine Seltenheit sind. Zu großen Abweichungen kommt es insbesondere dann, wenn mit ein und derselben Schaltung Signale von unterschiedlichen Signallieferanten verarbeitet werden, z. B. von Recordern, Kameras oder Bildplatten.

Um auch bei sehr großen Spitzenspannungen (hohen Weißpegeln), die deutlich über dem Normwert liegen, noch eine zufriedenstellende digitale Auflösung zu erhalten, wird in der Praxis teilweise so vorgegangen, daß entweder ein A/D-Wandler verwendet wird, dessen Referenzspannung deutlich über der Normspitzenspannung liegt, oder das zu verarbeitende Signal wird nur so wenig verstärkt, daß der größtmögliche Spitzenwert unter der Referenzspannung bleibt. In beiden Fällen besteht der erhebliche Nachteil, daß dann, wenn Signale empfangen werden, die sich mit ihren Amplituden dicht an der Norm bewegen, die Auflösung beim Digitalisieren weit unter der eigentlich erreichbaren Auflösung bleibt.

Um den eben beschriebenen Nachteil zu vermeiden, ist es im Stand der Technik auch bekannt, das zu digitalisierende Signal nicht mit einem festen Faktor zu verstärken, sondern mit einem variablen Faktor zu verstärken, dessen Größe vom Wert der Amplitude des Horizontal-Synchronisierpulses abhängt. Im Normsignal beträgt die Amplitude 250 mV. Steigt diese Amplitude an, wird das zu verarbeitende Signal nicht mehr mit dem Faktor 2 verstärkt, sondern nur noch so stark, daß trotz der 250 mV übersteigenden Amplitude nach dem Verstärken nur ein Wert von 500 mV erhalten wird. Entsprechend werden alle anderen Signalanteile verstärkt. Ein integriertes Bauteil, das nach diesem Prinzip arbeitet, ist das von der Firma Valvo gelieferte Bauteil TDA 9045. Es dient zum Klemmen und zum Verstärken eines FBAS-Signales. Der variable Verstärkungsfaktor hat zur Folge, daß in einem anschließenden A/D-Wandler (z. B. PNA 7509 der Firma Valvo) immer die maximal mögliche Auflösung beim Digitalisieren ausgenutzt werden kann.

Nachteilig bei der eben beschriebenen Vorgehensweise ist, daß es mit einigem Aufwand verbunden ist, statt eines Wechselspannungsverstärkers mit festem Verstärkungsfaktor einen solchen mit variablem Verstärkungsfaktor zu verwenden.

Es bestand demgemäß das Problem, eine A/D-Wandlerschaltung anzugeben, die bei einfachem Aufbau ein Wandeln mit guter Auflösung auch bei nicht normgerechten Eingangspegeln zuläßt.

## DARSTELLUNG DER ERFINDUNG

Die erfindungsgemäße A/D-Wandlerschaltung zum Digitalisieren analoger Fernsehsignale weist folgende Merkmale auf:

- einen A/D-Wandler zum Zuordnen einer Anzahl m jeweils gleicher Teilspannungen $U\_T$ zu einer Signalspannung $U\_S$, wobei sich jede Teilspannung $U\_T$ als Referenzspannung/n berechnet, mit n = höchstmöglicher digitaler Wert,
- und eine Spannungssteuerschaltung, die die Referenzspannung abhängig von einer Signalamplitude des Fernsehsignales so steuert, daß sie mit zunehmender Signalamplitude zunimmt.

Bei der erfindungsgemäßen Schaltung wird also nicht der Verstärkungsfaktor eines Wechselspannungsverstärkers geändert, sondern es wird die Referenzspannung, also eine Gleichspannung variiert. Ein Variieren einer Gleichspannung ist aber mit geringerem schaltungstechnischem Aufwand verbunden als das Variieren des Verstärkungsfaktors eines Wechselspannungsverstärkers.

Als Maß für das Variieren der Referenzspannung kann die Amplitude des Horizontal-Synchronisierpulses verwendet werden, wie beim bekannten Wandler. Vorteilhafter ist es jedoch, die Spannungssteuerschaltung so auszubilden, daß sie

- die Spitzenspannung im Fernsehsignal, bezogen auf den Schwarzschulterpegel im Signal, detektiert,
- die Spitzenspannung in einer Kondensatoranordnung speichert, wobei die Speicherspannung von der Spitzenspannung aus mit einer Abfallzeitkonstanten fällt,

- und die Speicherspannung als Referenzspannung an den A/D-Wandler gibt.

Die so ausgebildete Schaltung ist nicht mehr darauf angewiesen, daß das Verhältnis zwischen Weißpegel und Synchronisierpulsamplitude normgerecht ist. Vielmehr wird unmittelbar die Amplitude desjenigen Signals gemessen, das digitalisiert werden soll. Daher läßt sich praktisch immer optimale Auflösung beim Digitalisieren erzielen. Weiterhin besteht der Vorteil, daß sich auch Signale gut verarbeiten lassen, die gar keinen Horizontal-Synchronisierpuls mehr enthalten, z. B. die Farbwertsignale R, G und B. Aus diesen Signalen ist der Horizontal-Synchronisierpuls bereits abgetrennt, der gesondert verarbeitet wird.

Sind mehrere Fernsehsignale zu digitalisieren, z. B. die eben genannten Farbanteilsignale, ist es erforderlich, daß die Verstärkung für alle Signale gleich erfolgt. Dies, um keine Farbverfälschungen durch unterschiedliche Verstärkungen herbeizuführen. Diesem Erfordernis kann bei der erfindungsgemäßen Schaltung leicht genügt werden, und zwar dadurch, daß als zu speichernde Spitzenspannung die größte Spitzenspannung von allen Fernsehsignalen verwendet wird. Aus diesem Signal wird, wie oben angegeben, die Referenzspannung gebildet, die dann an alle A/D-Wandler für die verschiedenen Signale ausgegeben wird.

Aufgrund der Funktionsweise eines A/D-Wandlers ist es erforderlich, die Referenzspannung auf einen Minimal- und einen Maximalwert zu begrenzen. In Versuchen hat sich herausgestellt, daß es von Vorteil ist, den Maximalwert der Referenzspannung auf denjenigen Wert zu legen, den der verwendete A/D-Wandler maximal verarbeiten kann, daß es aber für die Minimalspannung besser ist, eine Spannung zu verwenden, die der Normspitzenspannung entspricht, also z. B. eine Spannung von 2 V als Referenzspannung bei einer Normspitzenspannung von 1 V. Dadurch wird einerseits erreicht, daß sich auch sehr starke Eingangssignale mit voller Auflösung digitalisieren lassen. Andererseits werden beim Digitalisieren schwächerer Signale keine Fehler hervorgerufen, wie sie entstehen, wenn ein A/D-Wandler nahe beim Minimalwert seiner Referenzspannung arbeitet. Derartige Fehler wirken sich auf schwache Signale stark aus.

KURZE BESCHREIBUNG DER FIGUREN

Fig. 1 Blockschaltbild einer A/D-Wandlerschaltung mit einem einzigen A/D-Wandler und einer Spannungssteuerschaltung, die die Referenzspannung steuert;

Fig. 2 Blockschaltbild entsprechend dem von Fig. 1, jedoch mit genauerer Darstellung der Spannungssteuerschaltung und nichtdetaillierter Darstellung des A/D-Wandlers;

Fig. 3 Blockschaltbild einer A/D-Wandlerschaltung zum unmittelbaren Verarbeiten von R-, G- und B-Signalen, mit drei A/D-Wandlern und einer gemeinsamen Spannungssteuerschaltung; und

Fig. 4$\mu$ Blockschaltbild zum Verarbeiten von Y-, U- und V-Signalen, mit zwei A/D-Wandlern und einer gemeinsamen Spannungssteuerschaltung.

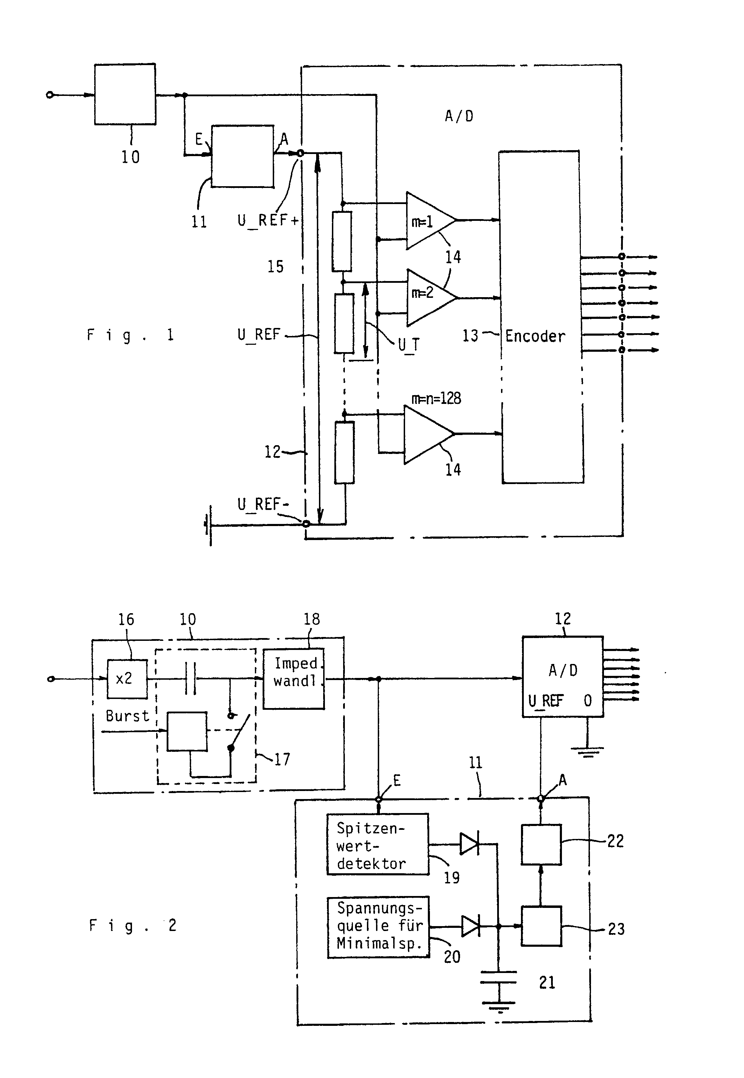

Die Blockschaltbilder der Fig. 1 und 2 zeigen eine Eingangsschaltung 10, eine Spannungssteuerschaltung 11 und einen A/D-Wandler 12. Wie aus Fig. 1 erkennbar, verfügt der A/D-Wandler 12 über einen Encoder 13, über n = 128 Vergleicher 14 und über ebenfalls n = 128 jeweils gleiche Widerstände 15. Die Widerstände liegen zwischen zwei Referenzspannungsanschlüssen mit den Spannungen U_REF- bzw. U_REF+. Der Anschluß mit der Spannung U_REF- ist mit Masse verbunden, weist also das Potential 0 auf. Zwischen den beiden Anschlüssen fällt die Referenzspannung U_REF ab. An jedem einzelnen der Widerstände 15 fällt dementsprechend die Teilspannung U_T = U_REF/n ab.

An jedem der Vergleicher 14 liegt eine andere Summe von m Teilspannungen an. Jeder Vergleicher vergleicht das ihm zugeführte FBAS-Signal mit der für ihn gültigen Vergleichsspannung und gibt ein Signal an den Encoder 13 aus, wenn die Spannung des FBAS-Signals seine Vergleichsspannung übersteigt. Der Encoder bildet aus den ihm zugeführten Signalen ein digitales 7-Bit-Ausgangssignal.

Der n-te Vergleicher 14 gibt dann ein Signal hohen Pegels aus, wenn der aktuelle Spannungswert des FBAS-Signals größer ist als die Referenzspannung U_REF. Maximale Auflösung wird dann erzielt, wenn· die Referenzspannung U_REF der Spitzenspannung des FBAS-Signals entspricht.

Die eben genannte Bedingung wird durch die Funktion der Spannungssteuerschaltung 11 realisiert. Wie dies erfolgt, wird nun anhand von Fig. 2 erläutert.

Fig. 2 zeigt die Eingangsschaltung 10 und die Spannungssteuerschaltung 11 detaillierter, als dies in Fig. 1 der Fall ist. Die Eingangsschaltung 10 weist einen Verstärker 16 mit dem Verstärkungsfaktor 2, eine Klemmschaltung 17 und einen Impedanzwandler 18 auf. Die Klemmschaltung 17 klemmt den Schwarzschulterpegel des Eingangssignals mit Hilfe des Burstimpulses auf einen vorgebenen Wert. Der Burstimpuls kann z.B. aus dem Eingangssignal abgeleitet werden, wenn es sich um ein FBAS- oder Y-Signal handelt, aber es kann auch von einem anderen Schaltungsteil her bezogen werden, was insbesondere dann der Fall sein wird, wenn das Eingangssignal nicht ein FBAS-Signal ist, wie für die Fig. 1 und 2 angenommen, sondern z.B. ein Farbwertsignal R, G oder B.

Es sei darauf hingewiesen, daß die Eingangsschaltung 17 eine übliche Schaltungsgruppe ist, was auch für den A/D-Wandler 12 gilt. Neu ist der Aufbau der Spannungssteuerschaltung 11.

Diese Spannungssteuerschaltung 11 verfügt über einen Spitzenwertdetektor 19, eine Spannungsquelle 20 für eine Minimalreferenzspannung, einen Kondensator 21, einen Impedanzwandler 22 und einen Begrenzer 23 zum Begrenzen der Referenzspannung U__REF auf einen Maximalwert. Der Spitzenwertdetektor 19 detektiert den Spitzenspannungswert im FBAS-Signal, wie er es über einen Eingangsanschluß E von der Eingangsschaltung 10 her erhält. Die Spitzenspannung wird im Kondensator 21 gespeichert und über den Impedanzwandler 22 und den Begrenzer 23 an einem Ausgangsanschluß A als Referenzspannung U__REF an den A/D-Wandler 12 ausgegeben. Als Dauerspannung liegt am Kondensator 21 die von der Spannungsquelle 20 ausgegebene Spannung an. Diese beträgt beim Ausführungsbeispiel 2 V. Liegt die ermittelte Spitzenspannung höher, wird der Kondensator 21 schnell auf den höheren Wert aufgeladen. Er entlädt sich dann mit einer Abfallzeitkonstanten. Die Speicherspannung entspricht dementsprechend maximal der Spitzenspannung und minimal der Spannung, wie sie von der Spannungsquelle 20 ausgegeben wird. Liegt die Speicherspannung über derjenigen, die vom Begrenzer 23 vorgegeben wird, wird die Referenzspannung auf den vom Begrenzer 23 vorgegebenen Wert begrenzt. Beim Ausführungsbeispiel sind dies 3,5 V. Die Abfallzeitkonstante der Speicheranordnung ist so gewählt, daß eine Spannung von z. B. 3 V innerhalb einiger Zehntelsekunden im wesentlichen auf denjenigen Wert fällt, der dauernd von der Spannungsquelle 20 als Minimalreferenzspannung ausgegeben wird. Die genannte Zeitkonstante ist nicht kritisch. Vorzugsweise liegt sie zwischen einigen Zehntelsekunden und einigen Sekunden. Bei ihrer Wahl ist lediglich darauf zu achten, daß es bei plötzlichen Helligkeitsänderungen nicht zu sichtbarer Auflösungsverschlechterung im digitalisierten Ausgangssignal kommt.

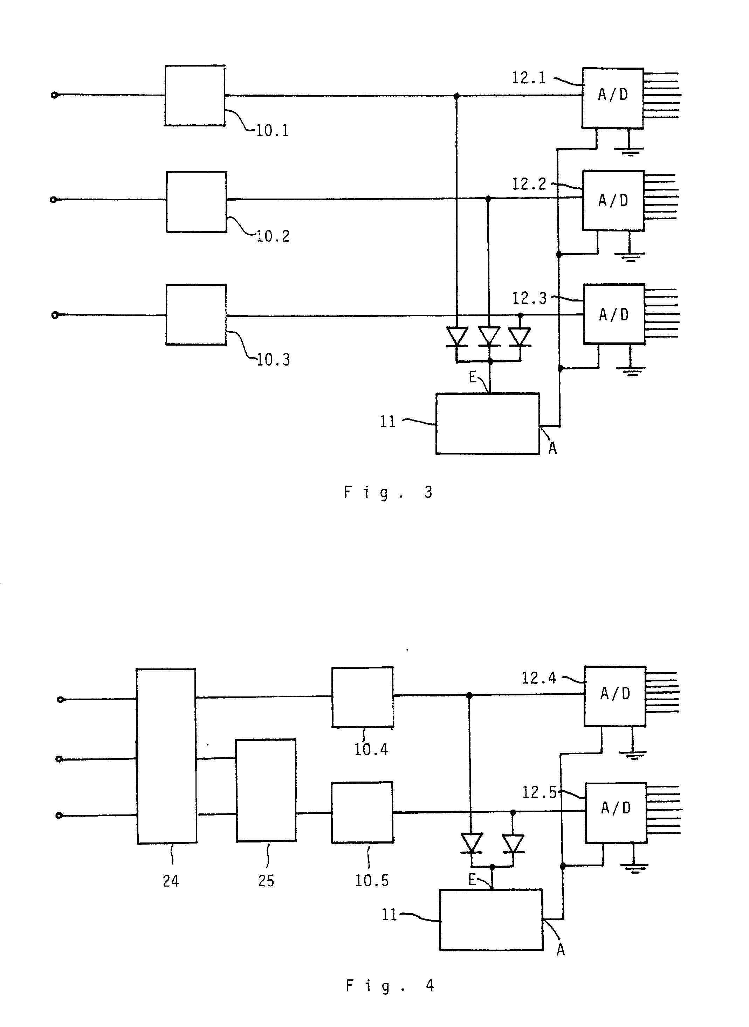

Die Fig. 3 und 4 veranschaulichen Anwendungen, bei denen nicht ein einziges Fernsehsignal verarbeitet wird, wie das FBAS-Signal bei den Ausführungsformen der Fig. 1 und 2, sondern daß mehrere Signale verarbeitet werden. Beim Ausführungsbeispiel gemäß Fig. 3 werden unmittelbar die Farbwertsignale R, G und B verarbeitet. Beim Ausführungsbeispiel gemäß Fig. 4 werden diese Signale dagegen nicht unmittelbar, sondern mittelbar verarbeitet, und zwar dadurch, daß sie in das Helligkeitssignal Y und die Farbdifferenzsignale U und V gewandelt werden.

Beim Ausführungsbeispiel gemäß Fig. 3 wird jedes der drei genannten Farbanteilsignale direkt über eine Eingangsschaltung 10.1 bzw. 10.2 bzw. 10.3 zu einem A/D-Wandler 12.1 bzw. 12.2 bzw. 12.3 geleitet. Die Ausgangssignale der Eingangsschaltungen werden außerdem, gekoppelt über Dioden, dem Eingang E der Spannungssteuerschaltung 11 zugeführt. Diese ist genauso ausgebildet wie beim Ausführungsbeispiel gemäß Fig. 2. Dadurch, daß ihr alle zu digitalisierenden Analogsignale gekoppelt zugeführt werden, speichert sie die größte Spitzenspannung, die in den drei Farbwertsignalen vorkommt. Daraus bildet sie die Referenzspannung und gibt diese an die drei A/D-Wandler aus.

Das Ausführungsbeispiel gemäß Fig. 4 weist eine Matrixschaltung 24, einen Analogmultiplexer 25, zwei Eingangsschaltungen 10.4 und 10.5, eine Spannungssteuerschaltung 11 und zwei A/D-Wandler 12.4 und 12.5 auf. Aus den eingangsseitigen Farbwertsignalen R, G und B bildet die Matrixschaltung das Helligkeitssignal Y und die Farbdifferenzsignale U und V. Um einen A/D-Wandler einsparen zu können, werden die Farbdifferenzsignale U und V durch den analogen Multiplexer 25 seriell an die Eingangsschaltung 10.5 ausgegeben. Die andere Eingangsschaltung 10.4 erhält das Helligkeitssignal Y. Die Signale, die von den beiden Eingangsschaltungen 10.4 und 10.5 ausgegeben werden, gelangen unmittelbar an die A/D-Wandler 12.4 bzw. 12.5. Über Dioden gekoppelt werden sie außerdem der Spannungssteuerschaltung 11 zugeführt. Diese verarbeitet das gekoppelte Eingangssignal entsprechend, wie dies anhand von Fig. 3 erläutert wurde.

Es wird darauf hingewiesen, daß in der Spannungssteuerschaltung 11 die Signalquelle 20 zum Ausgeben der Minimalreferenzspannung und der Begrenzer 23 zum Festlegen der Maximalreferenzspannung entfallen können. Für optimale Arbeit der Spannungssteuerschaltung sind diese Funktionsgruppen jedoch von Vorteil. Der Begrenzer 23 begrenzt die Referenzspannung auf den maximalen Wert, mit dem der verwendete A/D-Wandler noch arbeiten kann. Die Signalquelle 20 gibt als Minimalreferenzspannung diejenige Spannung aus, die der Normspitzenspannung zugeordnet ist. Bei einem Verstärkungsfaktor von 2 des eingangsseitigen Verstärkers 16 und bei einer Normspitzenspannung von 1 V ist dies eine Minimalreferenzspannung von 2 V. Übliche A/D-Wandler mit einer Maximalreferenzspannung von z. B. 3,5 V kommen mit niedrigeren Referenzspannungen aus. Dieser mögliche untere Wert wird jedoch nicht genutzt, um ein Verfälschen des analogen Eingangssignals beim Digitalisieren aufgrund von Fehlern zu vermeiden, wie sie bei zu niedrigen Spannungen auftreten.

Bei allen Ausführungsbeispielen wird die Referenzspannung aus der auf den Schwarzschulterpegel des Fernsehsignals bezogenen Spitzenspannung gewonnen. Es ist jedoch auch möglich, die Referenzspannung abhängig von der Amplitude eines Horizontal-Synchronisierpulses zu ändern. Eine Wandlerschaltung, die derartig arbeitet, ist aber weniger genau als eine solche mit einer Spannungssteuerschaltung gemäß Fig. 2, da es eigentlich darauf ankommt, die Spitzenspannung, bezogen auf den Schwarzschulterpegel, richtig zu erfassen, was aber nicht gewährleistet ist, wenn in einem zu verarbeitenden Signal das Verhältnis zwischen der Spitzenspannung und der Synchronisierpulsamplitude nicht normgerecht ist.

## Patentansprüche

1. A/D-Wandlerschaltung zum Digitalisieren analoger Fernsehsignale (FBAS, R, G, B, Y, U, V) mit
   - einem A/D-Wandler (12) zum Zuordnen einer Anzahl m jeweils gleicher Teilspannungen $U\_T$ zu einer Signalspannung $U\_S$, wobei sich jede Teilspannung $U\_T$ als Referenzspannung/n berechnet, mit n = höchstmöglicher digitaler Wert,
   - und einer Spannungssteuerschaltung (11),

   dadurch gekennzeichnet, daß
   - die Spannungssteuerschaltung (11) so ausgebildet ist, daß sie die Referenzspannung abhängig von einer Signalamplitude des Fernsehsignals so steuert, daß sie mit zunehmender Signalamplitude ebenfalls zunimmt.

2. A/D-Wandlerschaltung nach Anspruch 1, dadurch gekennzeichnet, daß die Spannungssteuerschaltung (11) so ausgebildet ist, daß sie
   - die Spitzenspannung im Fernsehsignal , bezogen auf den Schwarzschulterpegel im Signal detektiert,
   - die Spitzenspannung in einer Kondensatoranordnung (11) speichert, wobei die Speicherspannung von der Spitzenspannung aus mit einer Abfallzeitkonstanten fällt,
   - und die Speicherspannung als Referenzspannung an den A/D-Wandler (12) gibt.

3. A/D-Wandlerschaltung nach Anspruch 1, dadurch gekennzeichnet, daß die Spannungssteuerschaltung (11) die ausgegebene Referenzspannung auf einen Minimalwert begrenzt, der der Normspitzenspannung entspricht.

4. A/D-Wandlerschaltung nach Anspruch 1, dadurch gekennzeichnet, daß die Spannungssteuerschaltung (11) die ausgegebene Referenzspannung auf einen Maximalwert begrenzt, der der maximalen Arbeitsspannung des A/D-Wandlers entspricht.

5. A/D-Wandlerschaltung nach Anspruch 1, dadurch gekennzeichnet, daß die Abfallzeitkonstante im Bereich einiger Zehntelsekunden bis einiger Sekunden liegt.

6. A/D-Wandlerschaltung nach Anspruch 1, dadurch gekennzeichnet, daß
   - mindestens ein weiterer A/D-Wandler (12.1, 12.2, 12.3; 12.4, 12.5) vorhanden ist, zum Wandeln jeweils eines weiteren Fernsehsignals,
   - und die Spannungssteuerschaltung (11) die größte Spitzenspannung aus allen Fernsehsignalen speichert und die Speicherspannung als Referenzspannung an alle A/D-Wandler ausgibt.

Fig. 1

Fig. 2

6

Fig. 3

Fig. 4